(19) Europäisches Patentamt
European Patent Office
Office européen des brevets

(11) Veröffentlichungsnummer: **0 006 626**
**B1**

(12) # EUROPÄISCHE PATENTSCHRIFT

(45) Veröffentlichungstag der Patentschrift: **15.12.82**

(51) Int. Cl.³: **G 03 F 7/10**, G 03 C 1/72, G 03 F 7/08

(21) Anmeldenummer: **79102168.6**

(22) Anmeldetag: **29.06.79**

(54) **Strahlungsempfindliches Gemisch und Verfahren zur Herstellung von Reliefbildern.**

(30) Priorität: **05.07.78 DE 2829512**

(43) Veröffentlichungstag der Anmeldung:
**09.01.80 Patentblatt 80/1**

(45) Bekanntmachung des Hinweises auf die Patenterteilung:
**15.12.82 Patentblatt 82/50**

(84) Benannte Vertragsstaaten:
**BE CH DE FR GB IT NL SE**

(56) Entgegenhaltungen:
**DE - A - 1 545 802**
**DE - A - 2 610 842**
**US - A - 3 779 778**

(73) Patentinhaber: **HOECHST AKTIENGESELLSCHAFT**
**Postfach 80 03 20**
**D-6230 Frankfurt/Main 80 (DE)**

(72) Erfinder: **Sander, Jürgen, Dr.**
**Berliner Ring 27**
**D-6233 Kelkheim/Ts. (DE)**
Erfinder: **Buhr, Gerhard, Dr.**
**Am Erdbeerstein 28**
**D-6240 Königstein/Ts. (DE)**
Erfinder: **Ruckert, Hans, Dr.**
**Erbsenacker 21**
**D-6200 Wiesbaden-Naurod (DE)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

Courier Press, Leamington Spa, England.

EP 0 006 626 B1

Strahlungsempfindliches Gemisch und Verfahren zur Herstellung von Reliefbildern

Die Erfindung betrifft ein neues strahlungsempfindliches Gemisch, das als wesentliche Bestandteile (a) eine Verbindung, die unter Einwirkung von aktinischer Strahlung eine Säure bildet, und (b) eine Verbindung enthält, die wenigstens eine durch Säure spaltbare Bindung aufweist.

Positiv arbeitende lichtempfindliche Kopiermaterialien, d.h. Materialien, deren Kopierschicht an den belichteten Stellen löslich wird, sind bekannt. Es haben sich vor allem die positiv arbeitenden Kopiermaterialien auf der Basis von o-Chinondiaziden in der Praxis durchgesetzt.

Die Lichtempfindlichkeit dieser Kopiermaterialien befriedigt häufig nicht. Eine Steigerung der Lichtempfindlichkeit kann man durch Verwendung katalytisch wirksamer lichtempfindlicher Systeme erreichen, da hierbei die Quantenausbeute größer also 1 wird. So wurde das bekannte Prinzip, durch photolytisch erzeugte Säuren Folgereaktionen auszulösen und dadurch ein Löslichwerden der belichteten Stellen zu erreichen, in neuerer Zeit für positiv arbeitende Systeme genutzt. Dabei dienen photochemisch erzeugte starke Säuren zur Spaltung von speziellen nieder- und hochmolekularen Acetalen und O,N-Acetalen, die also Hydroxyl- oder Amin-Komponenten aromatische Verbindungen enthalten (US—PS 3 779 778), und von Orthoestern und Amidacetalen (DE—OS 2 610 842).

Auch die Kombination von photochemischen Säurebildnern mit bestimmten Polyaldehyden und Polyketonen ist als positiv arbeitende Kopiermasse beschrieben worden, die bei Belichtung sichtbare Bilder liefert (US—PS 3 915 704, 3 915 706, 3 917 483, 3 932 514 und 2 892 712).

Diese Stoffgemische sind jedoch nicht frei von Nachteilen. Polyaldehyde und Polyketone, welche als wesentliche Bestandteile die Qualität der entsprechenden Aufzeichnungsmaterialien bestimmen, können in ihren stofflichen Eigenschaften nur begrenzt variiert und den praktischen Erfordernissen angepaßt werden.

Trotz der katalytischen Arbeitsweise besitzen die Gemische, die die oben genannten Acetale und O,N-Acetale enthalten, keine befriedigende praktische Lichtempfindlichkeit. Außerdem sind viele der erwähnten Acetale, O,N-Acetale und Orthoester nicht leicht zugänglich.

Aufgabe der Erfindung war es, ein neues, positiv arbeitendes, strahlungsempfindliches Gemisch vorzuschlagen, das eine hohe Empfindlichkeit für aktinische Strahlung, insbesondere kurzwelliges Licht und Elektronenstrahlung, besitzt und dessen Bestandteile leicht zugänglich sind.

Die Erfindung geht aus von einem strahlungsempfindlichen Gemisch, das (a) eine unter Einwirkung von aktinischer Strahlung Säure bildende Verbindung und (b) eine Verbindung enthält, die mindestens eine durch Säure spaltbare Bindung aufweist und deren Löslichkeit in einem flüssigen Entwickler durch Einwirkung von Säure erhöht wird.

Das erfindungsgemäße Gemisch ist dadurch gekennzeichnet, daß die durch Säure spaltbare Verbindung als säurespaltbare Gruppe wenigstens eine N-Acyliminocarbonatgruppe enthält.

Als aktinische Strahlung soll im Rahmen dieser Beschreibung jede Strahlung verstanden werden, deren Energie mindestens der des kurzwelligen sichtbaren Lichts entspricht. Geeignet ist insbesondere langwellige UV-Strahlung, aber auch Elektronen-und Laserstrahlung.

Als flüssige Entwickler sind insbesondere wäßrige Lösungen, vorzugsweise schwach alkalische Lösungen, aber auch organische Lösungsmittel, ggf. im Gemisch mit Wasser oder wäßrigen Lösungen, zu verstehen.

Von den durch Säure spaltbaren Verbindungen, die wenigstens eine N-Acyliminocarbonatgruppe enthalten, werden diejenigen bevorzugt, die der allgemeinen Formel I

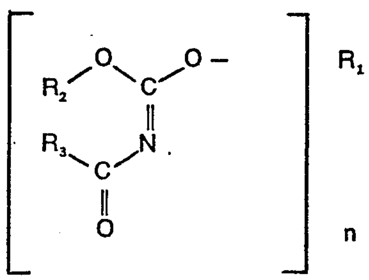

(I)

entsprechen, in der

$R_1$ einen n-wertigen aliphatischen, cycloaliphatischen oder aromatischen Rest,

$R_2$ und $R_3$ Alkyl- oder Arylreste bedeuten, wobei jeweils zwei der Reste $R_1$, $R_2$ und $R_3$ zu einem heterocyclischen Ring verbunden sein können und

n eine ganze Zahl von 1 bis 3, bevorzugt 1 oder 2, ist.

Dabei sind unter n-wertigen aromatischen Resten $R_1$ vorzugsweise ein- oder mehrkernige, ggf. durch Alkyl-, Aryl-, Alkoxy-, Aryloxy-, Acyl-, Acyloxy-, Alkylmercapto-, Aminoacyl-, Acylamino-, Carbalkoxy-, Hydroxy-, Halogen-, Nitro-, Sulfonyl- oder Cyangruppen substituierte aromatische oder heteroaromatische Reste, die bevorzugt 4 bis 20 C-Atome enthalten, zu verstehen.

Als n-wertige aliphatische oder cycloaliphatische Reste $R_1$ kommen verzweigte und unverzweigte, gesättigte und ungesättigte, cyclische und kettenförmige Reste in Betracht, die durch ggf. substituierte Arylreste, Halogenatome, Cyan-, Ester-, Aryloxy- oder Alkoxygruppen substituiert sein und Äther- oder Ketogruppen enthalten können.

Wenn $R_1$ ein acyclischer Rest ist, hat er im allgemeinen 2 bis 20, vorzugsweise 2 bis 10, Kohlenstoffatome. $R_1$ ist bevorzugt, insbesondere wenn $n = 1$ ist, ein cyclischer, vorzugsweise ein aromatischer Rest.

Wenn $R_2$ und $R_3$ Alkylreste bedeuten, können diese gesättigt oder ungesättigt, ketten- oder ringförmig sein und ggf. durch Halogenatome, Cyan-, Ester-, Hydroxy-, Alkoxy-, Aryloxy- oder Arylreste substituiert sein. $R_2$ und $R_3$ haben als Alkylreste im allgemeinen 1 bis 20, vorzugsweise 1 bis 8, Kohlenstoffatome.

Wenn $R_2$ und $R_3$ als Einzelsubstituenten vorliegen, sind sie bevorzugt ggf. substituierte aromatische Reste mit 6 bis 15, vorzugsweise 6 bis 12, C-Atomen.

Wenn zwei der Reste $R_1$, $R_2$ und $R_3$ zusammen einen heterocyclischen Ring bilden, kann dieser im allgemeinen 5 bis 8, vorzugsweise 5 oder 6, Ringglieder haben. Bevorzugt werden Verbindungen dieses Typs, in denen dieser Ring mit einem cycloaliphatischen oder bevorzugt einem aromatischen Ring durch Annellierung verbunden ist. Das Ringsystem kann durch Reste der oben angegebenen Art substituiert sein. Es kann allgemein 3 bis 20, vorzugsweise 5 bis 15, Kohlenstoffatome enthalten.

Außer den angegebenen Substituenten kann auch eine weitere Gruppierung der Formel I als Substituent in einem der Reste $R_2$ und $R_3$ vorkommen.

Eine besondere Gruppe von Verbindungen der allgemeinen Formel I mit $n = 1$ erhält man nach dem in Zhurnal Organischeskoi Khimii *3*, 480 (1967), beschriebenen Verfahren durch Umsetzung der leicht zugänglichen Acylisocyaniddichloride $R_3CON = CCl_2$, die z.B. in der DE—AS 11 78 422 beschrieben sind, mit ein- oder mehrwertigen aromatischen bzw. heteroaromatischen Hydroxyverbindungen.

In diesem Falle sind $R_1$ und $R_2$ ein- oder zweiwertige aromatische Reste oder zu einem ggf. substituierten Ring verbunden, $R_3$ ist ein Alkyl- oder Arylrest.

Bei Verwendung von bestimmten, mindestens zweiwertigen der im folgenden aufgeführten aromatischen Hydroxyverbindungen kann man auch polymere Verbindungen mit mehr als 3 N-Acyliminocarbonat-Einheiten im Molekül erhalten.

Als Acylisocyaniddihalogenide kommen beispielsweise Acetyl-, Chloracetyl-, Dichloracetyl-, Trichloracetyl-, Fluoracetyl-, Diphenylacetyl-, Propionyl-, Isobutyl-, Capryl-, Lauryl-, Stearyl-, Benzoyl-, 4-Chlor-benzoyl-, 4-Fluor-benzoyl-, 3-Äthoxy-4-nitro-benzoyl-, 4-Methyl-benzoyl-, Naphthoyl-, 2-Furoyl- und 2-Thienyl-isocyaniddihalogenid in Frage.

Geeignete Vertreter der aromatischen Hydroxyverbindungen sind: Phenol, 3,5-Dimethyl-phenol, p-Cyclohexyl-phenol, 4-(2-Phenyl-prop-2-yl)-phenol, p-(2,4-Dichlor-phenoxy)-phenol, Resorcinmonomethyläther, 5-Chlor-2-hydroxy-benzoesäureisoamylester, p-Chlorphenol, 5,6,7,8-Tetrahydro-1-naphtol, 2,4-Dinitro-phenol, 2-, 3- oder 4-Hydroxy-benzophenon, 4-Hydroxy-benzoesäuremethylphenylamid, Hydrochinonmonobenzyläther, p-Hydroxy-desoxybenzoin, 3- oder 4-Hydroxydiphenylmethan, 3-Brom-4'-hydroxybenzophenon, Brenzcatechin, 4-t-Butyl-brenzcatechin, 4,6-Di-t-butyl-brenzcatechin, 4-Chloracetyl-brenzcatechin, 1- und 2-Naphthol und 1-Brom-2-hydroxynaphthalin, Hydrochinon, 2-Methoxy-hydrochinon, 4,4'-Dihydroxy-diphenyläther, 4,4'-Dihydroxydiphenylsulfon, 4,4'-Dihydroxy-diphenylsulfid, 2,4- und 4,4'-Dihydroxy-benzophenon, Bisphenol A, 2,4-Dihydroxy-acetophenon, 3,4-Dihydroxy-diphenyl, Resorcin, 4-n-Hexyl-resorcin, 3,5-Dihydroxy-benzoesäureisoamylester, 2,4-Dihydroxy-benzoesäure-methyl-, -äthyl-, -isopropyl-, -butyl- und -isoamylester, 4-Acetyl-, 4-Propionyl-, 4-Valeryl-, 4-Benzoyl-, 4-Benzyl-, 4-Cyan-, 4-Chlor- und 4-Nitro-resorcin, Phloroglucin, 1,2,4-Trihydroxy-benzol, 2,4-, 2,5- und 2,7-Dihydroxy-naphthalin.

Eine weitere besondere Gruppe von Verbindungen der allgemeinen Formel I sind Verbindungen der allgemeinen Formel II

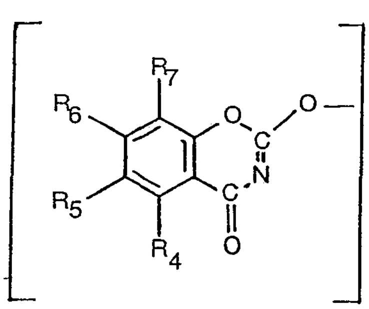

(II)

Dabei haben n und $R_1$ die oben angegebene Bedeutung.

$R_4$, $R_5$, $R_6$ und $R_7$ bedeuten Wasserstoff- oder Halogenatome, Aryl-, Aryloxy-, Alkyl-, Alkoxy-, Cyan-, Acyl-, Acyloxy-, Carbalkoxyreste oder Nitrogruppen, wobei auch jeweils zwei Reste $R_4$, $R_5$, $R_6$ und $R_7$ zu einem ggf. substituierten, vorzugsweise aromatischen Ring verbunden sein können.

Die Verbindungen mit Einheiten der allgemeinen Formel II sind leicht herstellbar durch Reaktion von aromatischen bzw. heteroaromatischen oder aliphatischen Hydroxyverbindungen $R_1(OH)_n$ mit den in der DE—OS 15 45 802 beschriebenen 2-Chlor-4H-1,3-benzoxazin-4-onen

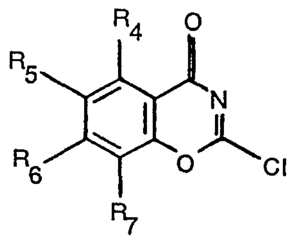

Dabei haben n, $R_1$ und $R_4$ bis $R_7$ die oben angegebene Bedeutung.

Unter aliphatischen Alkoholen $R_1(OH)_n$ sind in dieser Beschreibung ein- oder mehrwertige Alkohole zu verstehen, deren alkoholische OH-Gruppen alle an unterschiedlichen, gesättigten aliphatischen oder cycloaliphatischen C-Atomen stehen.

Beispiele für 2-Chlor-4H-1,3-benzoxazin-4-one sind:

2-Chlor-4H-1,3-benzoxazin-4-on, 6-Chlor-, 6-Methyl-, 6-Nitro-, 6-Chlor-8-methyl-, 6-Methoxy-, 8-Methyl- und 6-Chlor-8-nitro-2-chlor-4H-1,3-benzoxazin-4-on, 2-Chlor-4H-1,3-naphthoxazin-4-on und Hexahydro-2-chlor-4H-1,3-benzoxazin-4-on.

Neben den schon im Zusammenhang mit Formel I aufgeführten aromatischen Hydroxyverbindungen sind beispielsweise die im folgenden genannten aliphatischen Alkohole geeignet:

Benzylalkohol, Äthylenglykolmonobutyläther, Diäthylenglykolmonohexyläther, Triäthylenglykolmonobutyläther, Octanol, Äthylenglykolmonophenyläther, Decylalkohol und Dodecylalkohol, ggf. substituierte Athan-1,2-, Propan-1,3- und Butan-1,4-diole, Pentan-1,5-diol, n-Hexan-1,6-diol, 2-Äthyl-hexan-1,6-diol, Cyclohexan-1,4-diol, Nonan-1,7-diol, Nonan-1,9-diol, Decan-1,10-diol, Dodecan-1,12-diol, 1,4-Bis-(hydroxymethyl)-cyclohexan, Thiodipropylenglykol, Dibutylenglykol, 4,8-Bis-(hydroxymethyl)-tricyclodecan, n-Buten-(2)-1,4-diol, p-Xylylen-glykol, Di-, Tri-, Tetra-, Penta- und Hexaäthylenglykol, Di- und Tripropylenglykol und Polyäthylenglykole mit dem mittleren Molgewicht 200, 300, 400 und 600, Glycerin, 1,2,6-Hexan-triol, Trimethylolpropan und 1,4,7-Trihydroxyheptan.

Eine weitere besondere Gruppe von Verbindungen der allgemeinen Formel I sind Verbindungen der allgemeinen Formel III

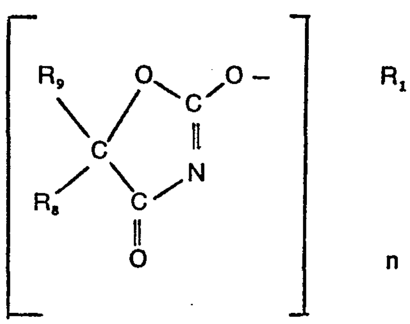

(III)

Dabei hat n die oben angegebene Bedeutung.

$R_1$ ist ein n-wertiger ggf. substituierter aromatischer Rest und $R_8$ und $R_9$ sind Wasserstoffatome oder Alkylreste.

Man kann die Verbindungen der allgemeinen Formel III leicht herstellen, indem man bei den in J.Chem.Soc. (London) (1950) 30, beschriebenen 2-Mercapto-1,3-oxazolin-4-onen

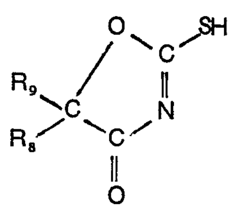

die Mercaptogruppe zunächst durch Chlorierung gegen Chlor austauscht und danach anschließend durch Reaktion mit aromatischen Hydroxyverbindungen $R_1(OH)_n$ Chlor durch Aryloxygruppen ersetzt. Dabei haben n, $R_1$, $R_8$ und $R_9$ die unter Formel III angegebene Bedeutung.

Als 2-Mercapto-1,3-oxazolin-4-one werden z.B. 5-Methyl-, 5,5-Dimethyl-, 5-Methyl-5-äthyl- und

5,5-Diäthyl-2-mercapto-1,3-oxazolin-4-on neben 2-Mercapto-1,3-oxazolin-4-on bevorzugt.

Als aromatische Hydroxyverbindungen finden die unter Formel I aufgeführten aromatischen Hydroxyverbindungen Verwendung.

Die oben beschriebenen bevorzugten Verbindungen der allgemeinen Formel I sind nach den angegebenen Verfahren durch aufeinanderfolgende Umsetzung leicht zugänglicher Säurechloride bzw. Salicylsäurechloride oder Cyanhydrine mit Kaliumrhodanid, Chlor und Hydroxyverbindungen einfach herstellbar.

Ein weiteres einfaches Verfahren zur Herstellung von Verbindungen der allgemeinen Formeln I und II ist die aufeinanderfolgende Umsetzung von Salicylsäureestern bzw. -säurechloriden mit Cyansäureestern und Hydroxyverbindungen.

Durch Verwendung unterschiedlicher N-Acyliminocarbonate bzw. von Gemischen derselben lassen sich die stofflichen Eigenschaften der damit hergestellten Aufzeichnungsmaterialien breit variieren.

Die erfindungsgemäßen N-Acyliminocarbonate sind äußerst säureempfindlich. Cyclische N-Acyliminocarbonate, die wenigstens einen aromatischen Ring enthalten, haben sich als beständigste Vertreter erwiesen.

Zur Herstellung der erfindungsgemäßen positiv arbeitenden strahlungsempfindlichen Gemische werden die beschriebenen N-Acyliminocarbonate gemischt mit Substanzen, die photochemisch und bzw. oder durch Einwirkung von energiereichen Strahlen Säuren bilden. Der Mengenanteil der N-Acyliminocarbonate an den nichtflüchtigen Bestandteilen des gesamten Gemischs kann dabei zwischen etwa 9 und 70, vorzugsweise zwischen 14 und 45 Gew.-%, liegen.

Vorzugsweise enthalten die Gemische ferner ein polymeres, bevorzugt wasserunlösliches Bindemittel, das in organischen Lösungsmitteln löslich ist. Da sich als Entwicklerflüssigkeiten für die belichteten Kopierschichten mit Vorteil wäßrig-alkalische Lösungen einsetzen lassen und diese im allgemeinen gegenüber Entwicklern auf Basis organischer Lösungsmittel vorgezogen werden, werden insbesondere solche Bindemittel bevorzugt, die in wäßrigen Alkalien löslich oder mindestens quellbar sind.

Die bei vielen Positiv-Kopiermaterialien bewährten Phenolharze, vor allem Novolake, haben sich auch bei den erfindungsgemäßen Gemischen als besonders brauchbar und vorteilhaft erwiesen. Sie fördern die starke Differenzierung zwischen den belichteten und unbelichteten Schichtpartien beim Entwickeln, besonders die höher kondensierten Harze mit substituierten Phenolen, z.B. Kresolen, als Formaldehyd-Kondensationspartner. Die Novolake können auch in bekannter Weise durch Umsetzung eines Teils ihrer Hydroxygruppen, z.B. mit Chloressigsäure, Isocyanaten, Epoxiden oder Carbonsäureanhydriden, modifiziert sein. Andere alkalilösliche Harze, wie Mischpolymerisate aus Maleinsäureanhydrid und Styrol, Vinylacetat und Crotonsäure, Methylmethacrylat und Methacrylsäure und dgl. sind ebenfalls als Bindemittel geeignet. Die Art und Menge der alkalilöslichen Harze kann je nach Anwendungszweck verschieden sein, bevorzugt sind Anteile am Gesamtfeststoff zwischen 30 und 90, besonders bevorzugt 55—85 Gew.-%. Zusätzlich können noch zahlreiche andere Harze mitverwendet werden, bevorzugt Vinylpolymerisate wie Polyvinylacetate; Polyacrylate, Polyvinyläther und Polyvinylpyrrolidone, die selbst durch Comonomere modifiziert sein können. Der günstigste Anteil and diesen Harzen richtet sich nach den anwendungstechnischen Erfordernissen und dem Einfluß auf die Entwicklungsbedingungen und beträgt im allgemeinen nicht mehr als 20% vom alkalilöslichen Harz. In geringen Mengen kann die lichtempfindliche Schicht für spezielle Erfordernisse wie Flexibilität, Haftung, Glanz etc. außerdem noch Substanzen wie Polyglykole, Cellulose-Derivate wie Äthylcellulose, Netzmittel, Farbstoffe und feinteilige Pigmente enthalten.

Als strahlungsempfindliche Komponenten, die beim Bestrahlen Säuren bilden bzw. abspalten, sind eine große Anzahl von bekannten Verbindungen und Mischungen, wie Diazonium-, Phosphonium-, Sulfonium- und Jodonium-Salze, Halogen-Verbindungen, Chinondiazidsulfochloride und Organometall-Organohalogen-Kombinationen geeignet.

An Diazonium-Salzen kommen die in der Diazotypie bekannten Verbindungen mit ausnutzbarer Absorption zwischen 300 und 600 nm in Frage. Einige erprobte und erfahrungsgemäß ausreichend lagerfähige Diazonium-Verbindungen sind in den Beispielen genannt; bevorzugt werden Verbindungen, die keine basischen Substituenten enthalten.

Die genannten Diazonium-, Phosphonium, Sulfonium- und Jodonium-Verbindungen werden in der Regel eingesetzt in Form ihrer in organischen Lösungsmitteln löslichen Salze, meist als Abscheidungsprodukt mit komplexen Säuren wie Borfluorwasserstoffsäure, Hexafluorphosphor-, Hexafluorantimon- und -arsensäure.

Es können aber auch Derivate der positive arbeitenden o-Chinondiazide verwendet werden. Die Azidität der beim Belichten von o-Naphthochinondiaziden entstehenden Indencarbonsäuren reicht meist nur knapp für eine ausreichende bildmäßige Differenzierung aus. Bevorzugt wird aus dieser Gruppe das Naphthochinon-1,2-diazid-4-sulfochlorid, bei dessen Belichtung drei Säurefunktionen gebildet werden, so daß ein relativ großer Verstärkungsfaktor bei der Spaltung der N-Acyliminocarbonate entsteht.

Grundsätzlich sind als halogenhaltige strahlungsempfindliche und Halogenwasserstoffsäure bildende Verbindungen alle auch als photochemische Radikalstarter bekannten organischen Halogen-verbindungen, beispielsweise solche mit mehr als einem Halogenatom an einem Kohlenstoffatom oder einem aromatischen Ring, brauchbar. Beispiele sind in den US—PS 3 515 552, 3 536 489 und 3 779 778 und der DE—OS 2 243 621 beschrieben. Die Wirkung dieser halogenhaltigen Verbindungen kann auch für die erfindungsgemäßen Positiv-Kopierschichten durch an sich bekannte Sensibilisatoren spektral beeinflußt und gesteigert werden.

Geeignet sind ferner bestimmte substituierte Trichlormethylpyrone, wie sie in der DE—OS 2 610 842 beschrieben sind.

Beispiele für geeignete Starter sind: 4-(Di-n-propylamino)-benzoldiazoniumtetrafluoroborat, 4-p-Tolylmercapto-2,5-diäthoxy-benzoldiazoniumhexafluorophosphat und -tetrafluoroborat, Diphenylamin-4-diazoniumsulfat, 4-Methyl-6-trichlormethyl-2-pyron, 4-(3,4,5-Trimethoxy-styryl)-6-trichlormethyl-2-pyron, 4-(4-Methoxy-styryl)-6-(3,3,3-trichlor-propenyl)-2-pyron, 2-Trichlormethyl-benzimidazol, 2-Tribrommethyl-chinolin, 2,4-Dimethyl-1-tribromacetyl-benzol, 3-Nitro-1-tribromacetyl-benzol, 4-Dibromacetyl-benzoesäure, 1,4-Bis-dibrommethyl-benzol, Tris-dibrommethyl-s-triazin, 2-(6-Methoxy-naphth-2-yl)-, 2-(Naphth-1-yl)-, 2-(Naphth-2-yl)-, 2-(4-Äthoxyäthyl-naphth-1-yl)-, 2-(Benzopyran-3-yl)-, 2-(4-Methoxy-anthrac-1-yl)-, 2-(Phenanthr-9-yl)-4,6-bis-trichlormethyl-s-triazin und die in den Beispielen angeführten Verbindungen.

Die Menge des Starters kann je nach seiner chemischen Natur und der Zusammensetzung des Gemischs ebenfalls sehr verschieden sein. Günstige Ergebnisse werden erhalten mit etwa 0,1 bis 10 Gew.-%, besogen auf den Gesamtfeststoff, bevorzugt sind 0,2 bis 5%. Besonders für Kopierschichten von Dicken über 10 $\mu$m empfiehlt es sich, relativ wenig Säurespender zu verwenden.

Schließlich können dem lichtempfindlichen Gemisch noch lösliche oder auch feinteilige dispergierbare Farbstoffe sowie je nach Anwendungszweck auch UV-Absorber zugesetzt werden. Die günstigsten Mengenverhältnisse der Komponenten lassen sich im Einzelfall durch Vorversuche leicht ermitteln.

Geeignete Lösungsmittel für das erfindungsgemäße Stoffgemisch sind Ketone, wie Methyläthylketon; chlorierte Kohlenwasserstoffe wie Trichloräthylen und 1,1,1-Trichloräthan, Alkohole wie n-Propanol, Äther wie Tetrahydrofuran, Alkoholäther wie Äthylenglykol-monoäthyläther und Ester wie Butylacetat. Es können auch Gemische verwendet werden, die zudem noch für spezielle Zwecke Lösungsmittel wie Acetonitril, Dioxan oder Dimethylformamid enthalten können. Prinzipiell sind alle Lösungsmittel verwendbar, die mit den Schichtkomponenten nicht irreversibel reagieren.

Die Wahl der Lösungsmittel ist jedoch auf das vorgesehene Beschichtungsverfahren, die Schichtdicke und die Trocknungsvorrichtung abzustimmen. Dünne Schichten bis ca. 5 $\mu$m werden für Versuchsmengen vorzugsweise auf der Schleuder durch Aufgießen aufgetragen. Mit Lösungen bis zu ca. 40% Feststoffgehalt sind so mit einmaligem Auftrag oder mit einer Streichrakel Schichtdicken von mehr als 60 $\mu$m erreichbar. Für beidseitige Beschichtung wird Tauchbeschichtung vorgezogen, wobei durch Verwendung von niedrig siedenden Lösungsmitteln schnelles Antrocknen von Vorteil ist. Bandbeschichtung erfolgt durch Antragen mittels Walzen, Breitschlitzdüsen oder Sprühen; Einzelplatten wie Zink- und Mehrmetall-Platten können durch Gießer-Antrag (curtain-coater) beschichtet werden.

Im Vergleich zu anderen Positiv-Schichten, besonders denen auf o-Naphthochinondiazid-Basis, ist die Herstellung dickerer Schichten vorteilhaft möglich, da die Lichtempfindlichkeit des erfindungsgemäßen lichtempfindlichen Gemischs verhältnismäßig wenig dickenabhängig ist. Belichtung und Verarbeitung von Schichtdicken bis ca. 100 $\mu$m und darüber ist möglich.

Bevorzugte Träger für dicke Schichten über 10 $\mu$m sind Kunststoffolien, die dann als temporäre Träger für Transferschichten dienen. Dafür und für Farbfolien werden Polyesterfolien, z.B. aus Polyäthylenterephthalat, bevorzugt. Polyolefinfolien wie Polypropylen sind jedoch ebenfalls geeignet. Als Schichtträger für Schichtdicken unter ca. 10 $\mu$m werden meist Metalle verwendet. Für Offsetdruckplatten können eingesetzt werden: mechanisch oder elektrochemisch aufgerauhtes und ggf. anodisiertes Aluminium, das zudem noch chemisch, z.B. mit Polyvinylphosphonsäure, Silikaten oder Phosphaten, vorbehandelt sein kann, außerdem Mehrmetallplatten mit Cu/Cr oder Messing/Cr als oberste Schicht. Für Hochdruckplatten können die erfindungsgemäßen Schichten auf Zink- oder Magnesium-Platten sowie deren handelsübliche mikrokristalline Legierungen für Einstufenätzverfahren aufgetragen werden, außerdem auf ätzbare Kunststoffe wie Polyoxymethylen. Für Tiefdruck- oder Siebdruckformen eignen sich die erfindungsgemäßen Schichten durch ihre gute Haftung und Ätzfestigkeit auf Kupfer- bzw. Nickel-Oberflächen. Ebenso lassen sich die erfindungsgemäßen Gemische als Photoresists beim Formteilätzen verwenden.

Schließlich kann die Beschichtung direkt oder durch Schichtübertragung vom temporären Träger erfolgen auf Leiterplatten-Materialien, die aus Isolierplatten mit ein- oder beidseitiger Kupfer-Auflage bestehen, auf Glas oder Keramik-Materialien, die ggf. haftvermittelnd vorbehandelt sind, und auf Silicium-Scheiben, für die in der Mikroelektronik schon Erfahrung mit Elektronenstrahl-Bebilderung vorliegt. Außerdem können Holz, Textilien und Oberflächen vieler Werkstoffe beschichtet werden, die vorteilhaft durch Projektion bebildert werden und resistent gegen die Einwirkung alkalischer Entwickler sind.

Für die Trocknung nach der Beschichtung können die üblichen Geräte und Bedingungen übernommen werden, Temperaturen um 100°C und kurzfristig bis 120°C werden ohne Einbuße an Strahlungsempfindlichkeit vertragen.

Zum Belichten können die üblichen Lichtquellen wie Röhrenlampen, Xenonimpulslampen, metallhalogendotierte Quecksilberdampf-Hochdrucklampen und Kohlebogenlampen verwendet werden.

Darüber hinaus ist bei den lichtempfindlichen N-Acyliminocarbonat-Schichten das Belichten in üblichen Projektions- und Vergrößerungs-Geräten unter dem Licht der Metallfadenlampen und Kontakt-Belichtung mit gewöhnlichen Glühbirnen möglich. Die Belichtung kann auch mit kohärentem Licht eines Lasers erfolgen Geeignet für die Zwecke vorliegender Erfindung sind leistungsgerechte kurzwellige Laser, beispielsweise Argon-Laser, Krypton Ionen-Laser, Farbstoff-Laser und Helium-Cadmium-Laser, die zwischen 300 und 600 nm emittieren. Der Laserstrahl wird mittels einer vorgegebenen programmierten Stricht- und/oder Raster-Bewegung gesteuert.

Das Bestrahlen mit Elektronenstrahlen ist eine weitere Bebilderungsmöglichkeit. Elektronenstrahlen können das erfindungsgemäße Gemische wie auch viele andere organische Materialien durchgreifend zersetzen und vernetzen, so daß ein negatives Bild entsteht, wenn die unbestrahlten Teile durch Lösungsmittel oder Belichten ohne Vorlage und Entwickeln entfernt werden. Bei geringerer Intensität und/oder höherer Schreibgeschwindigkeit des Elektronenstrahls bewirkt dagegen der Elektronenstrahl eine Differenzierung in Richtung höherer Löslichkeit, d.h. die bestrahlten Schichtpartien können vom Entwickler entfernt werden. Es wurde gefunden, daß die erfindungsgemäßen Schichten erheblich elektronenstrahl-empfindlicher als übliche Naphthochinondiazid-Schichten sind und — wie in den Beispielen erläutert — ein breiter Bandbereich vergleichsweise geringer Energieeinwirkung von Elektronenstrahlen ausgenutzt werden kann. Die Wahl der günstigsten Bedingungen kann durch Vorversuche leicht ermittelt werden.

Die bildmäßig belichtete oder bestrahlte Schicht kann mit praktisch den gleichen Entwicklern wie für handelsübliche Naphthochinondiazid-Schichten und Kopierlacke entfernt werden bzw. die neuen Schichten können in ihren Kopierbedingungen vorteilhaft auf die bekannten Hilfsmittel wie Entwickler und programmierte Sprühentwicklungsgeräte abgestimmt werden. Die wäßrigen Entwicklerlösungen können z.B. Alkaliphosphate, -silikate oder -hydroxide und ferner Netzmittel sowie kleinere Anteile organischer Lösungsmittel enthalten. In bestimmten Fällen sind auch Lösungsmittel-Wasser-Gemische als Entwickler brauchbar. Die Wahl des günstigsten Entwicklers kann durch Versuche mit der jeweils verwendeten Schicht ermittelt werden. Bei Bedarf kann die Entwicklung mechanisch unterstützt werden. Zur Erhöhung der Widerstandsfähigkeit beim Druck sowie der Resistenz gegen Auswaschemittel, Korrekturmittel und durch UV-Licht härtbare Druckfarben können die entwickelten Platten kurze Zeit auf erhöhte Temperaturen erwärmt werden, wie es für Diazoschichten aus der britischen Patentschrift 1 154 749 bekannt ist.

Erfindungsgemäß wird auch ein Verfahren zur Herstellung von Reliefbildern vorgeschlagen, bei dem man ein strahlungsempfindliches Aufzeichnungsmaterial aus einem Träger und einer Aufzeichnungsschicht, die als wesentliche Bestandteile (a) eine Verbindung, die unter Einwirkung von aktinischer Strahlung Säure bildet, und (b) eine Verbindung enthält, die mindestens eine durch Säure spaltbare Bindung aufweist und deren Löslichkeit in einem flüssigen Entwickler durch Einwirkung von Säure erhöht wird, bildmäßig mit aktinischer Strahlung in solcher Dosis bestrahlt, daß die Löslichkeit der Schicht in einem flüssigen Entwickler zunimmt, und die bestrahlten Schichtteile mittels eines Entwicklers entfernt. Das Verfahren ist dadurch gekennzeichnet, daß man eine Verbindung (b) verwendet, die als säurespaltbare Gruppe wenigstens eine N-Acyliminocarbonatgruppe enthält.

Wenn das Verfahren mit Elektronenstrahlung durchgeführt wird, sind neben den bekannten für sichtbares und nahes UV-Licht empfindlichen photolytischen Säurespendern auch solche geeignet, deren Absorptionsbereiche im kürzerwelligen Teil des elektromagnetischen Spektrums liegen und die damit gegenüber Tageslicht wenig empfindlich sind. Dies hat den Vorteil, daß man die Aufzeichnungsmaterialien ohne Lichtausschluß handhaben kann und daß die Materialien besser lagerfähig gemacht werden können.

Als Beispiele für derartige Starter sind Tribrommethylphenyl-sulfon, 2,2',4,4',6,6'-Hexabrom-diphenylamin, Pentabromäthan, 2,3,4,5-Tetrachlor-anilin, Pentaerythrittetrabromid, Clophen-Harz W, d.h. ein Chlorterphenylharz, oder chlorierte Paraffine zu nennen.

Im folgenden werden Beispiele für die erfindungsgemäßen lichtempfindlichen Gemische angegeben. Dabei wird zunächst die Herstellung einer Anzahl neuer N-Acyliminocarbonate beschrieben, die in erfindungsgemäßen Gemischen als säurespaltbare Verbindungen erprobt wurden. Sie wurden als Verbindungen 1 bis 30 durchnumeriert und kehren unter dieser Bezeichnung in den Anwendungsbeispielen wieder.

In den Beispielen stehen Gewichtsteile (Gt) und Volumteile (Vt) im Verhältnis von g zu ccm. Prozent- und Mengenverhältnisse sind, wenn nichts anderes angegeben ist, in Gewichtseinheiten zu verstehen.

Allgemeine Vorschrift A

Herstellung der in Tabelle 1 aufgeführten Verbindungen 1 und 2

Eine Lösung von 1 Mol Acylisocyaniddichlorid, 2 Molen Triäthylamin oder Pyridin und 2 Molen einer einwertigen bzw. 1 Mol einer zweiwertigen Hydroxyverbindung in einem inerten Lösungsmittel

wird 1—20 Stunden bei Raumtemperatur gerührt. Die organische Phase wird mit einer alkalischen Lösung gewaschen. Das Lösungsmittel wird nach dem Trocknen entfernt. Der verbleibende Rückstand wird nach bekannten Methoden gereinigt. Die angegebenen Ausbeuten sind nicht optimiert.

Tabelle 1

Verbindung der allgemeinen Formel I
$n = 1$; $R_3 = $ Phenyl

| Verbindung Nr. | $R_1$ | $R_2$ | Fp. (°C) | Ausbeute (% d. Th.) |
|---|---|---|---|---|
| 1 | 2-Naphthyl | 2-Naphthyl | 147—149 | 41 |
| 2 | Phenylen-1,2 | | 112—114 | 23 |

Allgemeine Vorschrift B

Herstellung der in den Tabellen 2 und 3 aufgeführten Verbindungen 3 bis 30

In eine Lösung oder Suspension von n Molen 2-Mercapto-4H-1,3-benzoxazin-4-on- bzw. 2-Mercapto-1,3-oxazolin-4-on-Derivaten in einem inerten Lösungsmittel leitet man bei Raumtemperatur 2 n Mole Chlor ein. Die Umsetzung verläuft momentan unter Temperaturerhöhung. Nach Entfernen der leichtflüchtigen Komponenten erhält man 2-Chlor-4H-1,3-benzoxazin-4-on- bzw. 2-Chlor-1,3-oxazolin-4-on-Derivate als ölige oder kristalline Rückstände. Die feuchtigkeitsempfindlichen Rückstände werden i.a. nicht gereinigt und sofort zur weiteren Umsetzung verwendet.

1 Mol einer n-wertigen Hydroxyverbindung, n Mole Triäthylamin oder Pyridin und der oben erhaltene Rückstand (n Mole) werden in einem inerten Lösungsmittel gelöst und 1—20 Stunden bei Raumtemperatur gerührt. Die Lösung wird mit einer alkalischen Lösung gewaschen. Das Lösungsmittel wird nach dem Trocknen entfernt. Der verbleibende Rückstand wird nach bekannten Methoden gereinigt. Die angegebenen Ausbeuten sind nicht optimiert.

Die Verbindungen der allgemeinen Formel II weisen im IR-Spektrum typische Banden um 1700 $cm^{-1}$ und um 1560 $cm^{-1}$ auf, Verbindungen mit Einheiten der allgemeinen Formel III zeigen charakteristische IR-Banden um 1760 $cm^{-1}$ und 1550 $cm^{-1}$.

Tabelle 2
Verbindungen der allgemeinen Formel II
$R_4 = H$

| Verbindung Nr. | n | $R_1$ | $R_5$ | $R_6$ | $R_7$ | Fp. (°C) | Ausbeute (% d. Th.) |
|---|---|---|---|---|---|---|---|
| 3 | 1 | Phenyl | H | H | H | 206—208 | 43 |
| 4 | 1 | 2-Naphthyl | H | H | H | 191—192 | 41 |
| 5 | 1 | 2-Naphthyl | Methoxy | H | H | 236—238 | 22 |
| 6 | 2 | 4,4′-Diphenylensulfon | H | H | H | 149—150 | 45 |
| 7 | 1 | 4-(2-phenyl-prop-2-yl)phenyl | H | H | H | 135—137 | 37 |
| 8 | 2 | $(-CH_2)_2-O-(CH_2-)_2$ | H | H | H | Öl | 66 |
| 9 | 1 | Phenyl | Methoxy | H | H | 250—252 | 28 |
| 10 | 1 | Phenyl | Chlor | H | H | 207—209 | 68 |
| 11 | 1 | 3-Methoxy-phenyl | benzo | | H | 208—212 | 23 |
| 12 | 1 | 2-Chlor-4-benzoyl-phenyl | H | H | Methyl | 154—156 | 82 |
| 13 | 1 | 4-Benzyloxy-phenyl | H | H | Methyl | 147—149 | 84 |
| 14 | 1 | 4-Phenylacetyl-phenyl | H | H | Methyl | 165—167 | 27 |
| 15 | 2 | 1,4-Cyclohexylen | H | H | Methyl | 232—234 | 23 |
| 16 | 1 | 2-Naphthyl | Chlor | H | Nitro | 267—270 | 64 |

Tabelle 3
Verbindungen der allgemeinen Formel III

| Verbindung Nr. | n | $R_1$ | $R_8$ | $R_9$ | Fp. (°C) | Ausbeute (% d.Th.) |
|---|---|---|---|---|---|---|
| 17 | 1 | 4-(2-phenyl-prop-2-yl) phenyl | Methyl | Methyl | 98— 99 | 43 |
| 18 | 1 | Phenyl | Methyl | Methyl | Öl | 47 |
| 19 | 1 | 2-Naphthyl | Methyl | Methyl | 149—150 | 21 |
| 20 | 2 | 1,2-Bis-(phenylen-(3)-oxy)-äthan | Methyl | Methyl | 188—191 | 66 |
| 21 | 2 | 2,2-Bis-phenylen-(4)-propan | Methyl | Methyl | Öl | 87 |
| 22 | 1 | 4-Benzyloxy-phenyl | H | H | 165—167 | 29 |
| 23 | 2 | Bis-phenylen-(4,4')-oxid | Methyl | Methyl | 179—181 | 63 |
| 24 | 1 | 4-(2,4-Dichlorphenoxy)-phenyl | Methyl | Methyl | 132—133 | 69 |
| 25 | 1 | 4-Cyclohexyl-phenyl | Methyl | Methyl | 98—100 | 46 |
| 26 | 1 | 1-Brom-2-naphthyl | Methyl | Methyl | 175—177 | 18 |
| 27 | 1 | 4-Chlor-2-isoamyl-oxycarbonyl-phenyl | Methyl | Methyl | Öl | 36 |
| 28 | 1 | 5,6,7,8-Tetrahydro-1-naphthyl | Methyl | Methyl | 154—156 | 55 |
| 29 | 2 | 1,4-Phenylen | Methyl | Methyl | 222—225 | 32 |
| 30 | 2 | 2-Methoxy-1,4-phenylen | Methyl | Methyl | 237—239 | 25 |

Beispiel 1

Eine Offset-Druckform wird in folgender Weise hergestellt:
Mit einer Beschichtungslösung, bestehend aus

94,6 Gt Methyläthylketon,
4,0 Gt Kresol-Formaldehyd-Novolak (Schmelzpunkt nach Kapillar-Methode DIN 53 181: 105—120°C),
1,2 Gt Verbindung 24,
0,2 Gt 2(4-Äthoxy-naphth-1-yl)-4,6-bis-trichlormethyl-s-triazin und
0,01 Gt Kristallviolett

beschichtet man eine elektrolytisch aufgerauhte und anodisierte Aluminium-Folie auf einer Schleuder (150 U/min), wobei sich ein Trockenschichtgewicht von ca. 1,5—2,0 g/m² ergibt. Das ausreichend getrocknete lichtempfindliche Material wird unter einer positiven Strich- und Raster-Vorlage mit einer 5 kW Metall-Halogenidlampe im Abstand von 110 cm 20 Sekunden belichtet, wonach ein starker blaugrüner Bildkontrast zu sehen ist. Entwickelt wird mit der folgenden Entwicklerlösung:

5,5% Natrium-metasilikat × 5 $H_2O$,
3,4% Trinatriumphosphat × 12 $H_2O$,
0,4% Natriumdihydrogenphosphat, wasserfrei,
90,7% vollentsalztes Wasser.

Innerhalb von 40 Sekunden werden die belichteten Schichtpartien entfernt, und die blaugefärbten unbelichteten Schichtteile bleiben als Druckschablone stehen. Die so hergestellte Offsetdruckform wird wie üblich mit fetter Farbe eingefärbte und in die Druckmaschine gespannt. Zur Lagerung kann die Platte mit handelsüblichen Konservierungsmitteln überwischt werden. Nach 50 000 Drucken wird der Druckversuch bei noch intakter Druckform abgebrochen. Die erreichbare hohe Druckauflage kann durch Nacherhitzen der entwickelten Druckform auf ca. 230—240°C noch deutlich gesteigert werden.

Beispiel 2

Das Beispiel 1 wird wiederholt, wobei anstelle der Verbindung 24 gleiche Gewichtsmengen der Verbindungen 19 oder 14 eingesetzt werden. Belichtet wird 35 Sekunden unter den im Beispiel 1 genannten Bedingungen, entwickelt mit der folgenden Entwicklerlösung:

0,6% NaOH
0,5% Natriummetasilikat x 5 $H_2O$,
1,0% n-Butanol,
97,9% vollentsalztes Wasser.

Auch in diesem Falle wird eine für hohe Auflagen geeignete positive Druckform erhalten.

Beispiele 3—6

Auf drahtgebürstete Aluminiumfolie ca. 2 μm dick aufgetragene Schichten der Zusammensetzung

74% Novolak nach Beispiel 1,
22% Acyliminocarbonat,
3,8% Säurespender und
0,2% Farbstoff

werden mit 11-kV-Elektronen bestrahlt. Im Beispiel 6, in dem ein chlorsubstituiertes Acyliminocarbonat ohne zusätzlichen Säurespender eingesetzt wird, ist der Novolakanteil auf 77,8% erhöht. Unter den in der Tabelle 4 genannten Bedingungen werden die bestrahlten Stellen beim Behandeln mit dem Entwickler aus Beispiel 1 ausgewaschen.

Tabelle 4

| Beispiel | Verbindung Nr. | Säurespender | eingestrahlte Energie (Joule/cm²) | Entwicklungszeit (s) |
|---|---|---|---|---|
| 3 | 17 | 4-(2,4-Dimethoxystyryl)-6-trichlormethyl-2-pyron | $1—10 \cdot 10^{-2}$ | 30 |
| 4 | 23 | 2-(4,7-Dimethoxy-naphth-1-yl)-4,6-bis-trichlormethyl-s-triazin | $1—15 \cdot 10^{-2}$ | 15 |
| 5 | 23 | Chlorparaffinharz | $3—40 \cdot 10^{-2}$ | 18 |
| 6 | 24 | ohne | $10—30 \cdot 10^{-2}$ | 10 |

Die Schichten aus den Beispielen 5 und 6 sind praktisch unemfindlich gegenüber dem Licht der üblicherweise in der Reproduktionstechnik verwendeten Lampen.

Beispiel 7

Eine Aluminiumplatte mit mechanish aufgerauhter Oberfläche wird mit einer Lösung aus

4,7 Gt Novolak nach Beispiel 1,
1,4 Gt Verbindung 6,
0,23 Gt 2-(Acenaphth-5-yl)-4,6-bistrichlormethyl-s-triazin,
0,02 Gt Kristallviolett-Base und
93,65 Gt Butan-2-on

schleuderbeschichtet, so daß nach dem Trocknen eine Schichtdicke von etwa 1,5 μm resultiert. Die Schicht wird mit einem Argon-Ionen-Laser von 25 W Lichtleistung über alle Spektrallinien bildmäßig bestrahlt, wobei der Laserstrahl optisch auf einen Fleck von 5 μm Durchmesser fokussiert wird. Die

Empfindlichkeit der Schicht reicht aus, daß die Schreibgeschwindigkeit des Lasers auf mehr als 70 m/s gesteigert werden kann. Die belichteten Schichtteile werden beim Behandeln mit 0,32-prozentiger wäßriger Natronlauge in 30 Sekunden herausgelöst. Durch Einfärben der unbestrahlten Bereiche mit fetter Farbe läßt sich die Laserspur noch deutlicher hervorheben.

Gleiche Ergebnisse werden erhalten, wenn als Schichtträger eine Aluminiumplatte mit elektrolytisch aufgerauhter und anodisierter Oberfläche verwendet wird. Die erforderliche Entwicklungszeit beträgt dann eine Minute.

Beispiel 8

Die Stabilität bei thermischer Belastung der die neuen säurespaltbaren Verbindungen enthaltenden Schichten zeigt das folgende Beispiel:

Eine Beschichtungslösung entsprechend Beispiel 1, in der als Säurespender anstelle des dort genannten Triazins gleiche Gewichtsmengen 2-(6-Methoxy-5-methyl-naphth-2-yl)-4,6-bis-trichlormethyl-s-triazin verwendet werden, wird auf gebürstete Aluminiumfolie so aufgeschleudert, daß die getrocknete Schicht ca. 1,5 $\mu$m dick ist.

Dieses Material wird in einem Trockenschrank 1 Stunde auf 100°C erhitzt, 15 Sekunden unter den in Beispiel 1 genannten Bedingungen belichtet und in 1,5 Minuten durch Schwenken in dem Entwickler von Beispiel 1 zu einem positiven Abbild der Vorlage entwickelt, das sich als Offset-Druckform eignet.

Beispiel 9

Platten aus gebürstetem Aluminium werden durch Tauchen in Lösungen von

10,64 Gt Novolak nach Beispiel 1,
3,20 Gt N-Acyliminocarbonat und
0,16 Gt 2-[4-(2-Äthoxy-äthoxy)-naphth-1-yl]-4,6-bis-trichlormethyl-s-triazin in
86,0 Gt Methyläthylketon

beschichtet, nach dem Herausziehen und Abdunsten des Lösungsmittels 20 Sekunden in einem warmen Luftstrom getrocknet und durch eine Strichvorlage, die von einer 1 mm starken Glasplatte bedeckt ist, belichtet. Das Belichtungsgerät ist mit vier Leuchtstoffröhren von 40 W im Abstand von 4 cm bestückt. Die Entfernung der Röhrenperipherie von der Plattenoberfläche beträgt ca. 5 cm. Die Belichtungszeiten sind bei Verwendung der einzelnen N-Acyliminocarbonate der Tabelle 5 zu entnehmen. Die Entwicklung zu einem positiven Abbild der Vorlage erfolgt durch Schwenken in dem Entwickler aus Beispiel 1.

Tabelle 5

| Verbindung | Belichtungszeit (Sekunden) | Verbindungen | Belichtungszeit (Sekunden) |
|---|---|---|---|
| 1 | 20 | 16 | 20 |
| 2 | 10 | 17 | 5 |
| 3 | 5 | 18 | 9 |
| 4 | 10 | 19 | 20 |
| 5 | 15 | 20 | 20 |
| 6 | 10 | 21 | 25 |
| 7 | 5 | 22 | 10 |
| 8 | 40 | 23 | 10 |
| 9 | 9 | 24 | 30 |
| 10 | 8 | 25 | 10 |
| 11 | 20 | 26 | 9 |
| 12 | 15 | 27 | 11 |
| 13 | 15 | 28 | 10 |
| 14 | 15 | 29 | 10 |
| 15 | 10 | 30 | 15 |

**Patentansprüche**

1. Strahlungsempfindliches Gemisch, das (a) eine unter Einwirkung von aktinischer Strahlung Säure bildende Verbindung und (b) eine Verbindung enthält, die mindestens eine durch Säure spaltbare Bindung aufweist und deren Löslichkeit in einem flüssigen Entwickler durch Einwirkung von Säure erhöht wird, dadurch gekennzeichnet, daß die durch Säure spaltbare Verbindung als säurespaltbare Gruppe mindestens eine N-Acyliminocarbonatgruppe enthält.

2. Strahlungsempfindliches Gemisch nach Anspruch 1, dadurch gekennzeichnet, daß die durch Säure spaltbare Verbindung (b) der allgemeinen Formel I

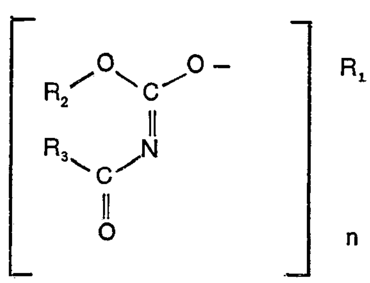

(I)

entspricht, in der

$R_1$ einen n-wertigen aliphatischen, cycloaliphatischen oder aromatischen Rest,

$R_2$ und $R_3$ Alkyl- oder Arylreste bedeuten, wobei jeweils zwei der Reste $R_1$, $R_2$ und $R_3$ zu einem heterocyclischen Ring verbunden sein können, und

n eine ganze Zahl von 1 bis 3 ist.

3. Strahlungsempfindliches Gemisch nach Anspruch 2, dadurch gekennzeichnet, daß die durch Säure spaltbare Verbindung (b) der Formel II

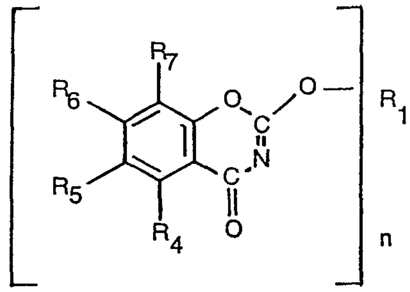

(II)

entspricht, in der

$R_1$ einen n-wertigen aliphatischen, cycloaliphatischen oder aromatischen Rest,

$R_4$, $R_5$, $R_6$ und $R_7$ Wasserstoff- oder Halogenatome, Alkyl-, Alkoxy-, Aryl-, Aryloxy-, Acyl-, Acyloxy-, Carbalkoxy- oder Nitrogruppen bedeuten, wobei jeweils zwei der Reste $R_4$ bis $R_7$ zu einem Ring verbunden sein können, und

n eine ganze Zahl von 1 bis 3 ist.

4. Strahlungsempfindliches Gemisch nach Anspruch 2, dadurch gekennzeichnet, daß die durch Säure spaltbare Verbindung (b) der Formel III

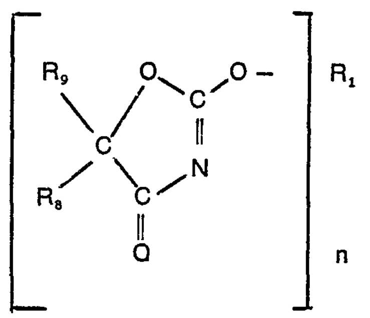

(III)

entspricht, in der

$R_1$ einen n-wertigen aromatischen Rest,

$R_8$ und $R_9$ Wasserstoffatome oder Alkylreste und

n eine ganze Zahl von 1 bis 3 bedeutet.

5. Strahlungsempfindliches Gemisch nach Anspruch 2, dadurch gekennzeichnet, daß n 1 oder 2 ist.

6. Strahlungsempfindliches Gemisch nach Anspruch 1, dadurch gekennzeichnet, daß es zusätzlich ein polymeres wasserunlösliches Bindemittel enthält.

7. Verfahren zur Herstellung von Reliefbildern, bei dem man ein strahlungsempfindliches Aufzeichnungsmaterial aus einem Schichtträger und einer Aufzeichnungsschicht, die (a) eine unter Einwirkung von aktinischer Strahlung Säure bildende Verbindung und (b) eine Verbindung enthält, die mindestens eine durch Säure spaltbare Bindung aufweist und deren Löslichkeit in einem flüssigen Entwickler durch Einwirkung von Säure erhöht wird, bildmäßig mit aktinischer Strahlung in solcher Dosis bestrahlt, daß die Löslichkeit der Schicht in einem flüssigen Entwickler zunimmt, und die bestrahlten Schichtteile mittels eines Entwicklers entfernt, dadurch gekennzeichnet, daß man eine Verbindung (b) verwendet, die als säurespaltbare Gruppe wenigstens eine N-Acyliminocarbonatgruppe enthält.

## Claims

1. A radiation-sensitive mixture containing (a) a compound which forms an acid under the influence of actinic radiation and (b) a compound which has at least one acid-cleavable bond and the solubility of which in a liquid developer is increased by the action of an acid, characterised in that the compound which is capable of being cleft by an acid contains as the acid-cleavable group at least one N-acyliminocarbonate group.

2. A radiation-sensitive mixture according to claim 1, characterised in that the compound (b) which is capable of being cleft by an acid corresponds to the general formula I

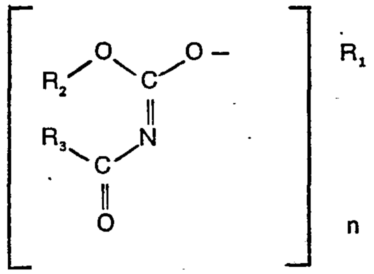

(I)

where

$R_1$ stands for a n-valent aliphatic, cycloaliphatic or aromatic radical,

$R_2$ and $R_3$ stand for alkyl or aryl radicals, and any two of the radicals $R_1$, $R_2$ and $R_3$ may be linked to form a heterocyclic ring, and

n is an integer from 1 to 3.

3. A radiation-sensitive mixture according to claim 2, characterised in that the compound (b) which is capable of being cleft by an acid corresponds to the formula II

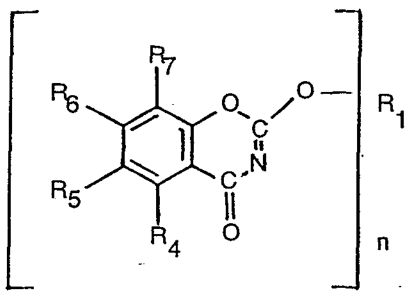

(II)

where

$R_1$ stands for a n-valent aliphatic, cycloaliphatic or aromatic radical,

$R_4$, $R_5$, $R_6$ and $R_7$ stand for hydrogen atoms or halogen atoms, alkyl, alkoxy, aryl, aryloxy, acyl, acyloxy, carbalkoxy or nitro groups, and any two of the groups $R_4$ to $R_7$ may be linked to form a ring, and

n is an integer from 1 to 3.

4. A radiation-sensitive mixture according to claim 2, characterised in that the compound (b) which is capable of being cleft by an acid corresponds to the formula III

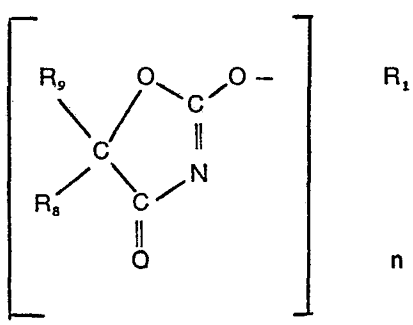

(III)

where

$R_1$ stands for a n-valent aromatic radical,

$R_8$ and $R_9$ stand for hydrogen atoms or alkyl radicals and

n represents an integer from 1 to 3.

5. A radiation-sensitive mixture according to claim 2, characterised in that n is 1 or 2.

6. A radiation-sensitive mixture according to claim 1 characterised in that it additionally contains a polymeric water-insoluble binder.

7. A process for producing relief images, in which a radiation-sensitive recording material which comprises a support and a recording layer containing (a) a compound forming an acid under the influence of actinic radiation and (b) a compound which has at least one acid-cleavable bond and the solubility of which in a liquid developer is increased by the action of an acid, is imagewise irradiated with actinic radiation of such a dosage that the solubility of the layer in a liquid developer is increased, and the irradiated layer areas are removed with the aid of a developer, characterised in that a compound (b) is used which contains as the acid-cleavable group at least one N-acyliminocarbonate group.

**Revendications**

1. Mélange sensible aux rayonnements contenant:

(a) un composé qui, sous l'effet d'un rayonnement actinique, donne naissance à un acide et,

(b) un composé qui comporte au moins une liaison susceptible d'être coupée par un acide et dont la solubilité dans un révélateur liquide est augmentée sous l'effet d'un acide, caractérisé en ce que le composé pouvant être coupé par un acide, renferme au moins un groupe iminocarbonate N-acylé, en tant que groupe susceptible d'être coupé par un acide.

2. Mélange sensible aux rayonnements selon la revendication 1, caractérisé en ce que le composé (b), pouvant être coupé par un acide, répond à la formule générale I

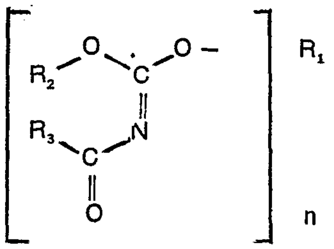

(I)

dans laquelle:

$R_1$ est un reste, de valence n, aliphatique, alicyclique ou aromatique,

$R_2$ et $R_3$ sont des restes alkyle ou aryle, deux des restes $R_1$, $R_2$, et $R_3$ pouvant le cas échéant, être reliés et former un hétérocycle, et,

n est un nombre entier de 1 à 3.

3. Mélange sensible aux rayonnements selon la revendication 2, caractérisé en ce que le composé (b), pouvant être coupé par un acide, répond à la formule II

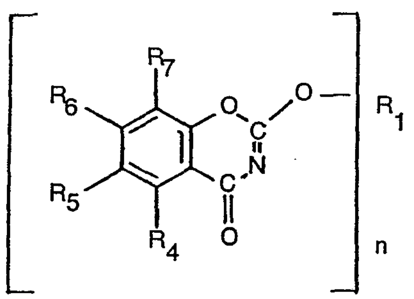

(II)

dans laquelle:

$R_1$ est un reste, de valence n, aliphatique, alicyclique ou aromatique,

$R_4$, $R_5$, $R_6$, $R_7$ représentent soit un atome d'hydrogène, soit un atome d'halogène, soit un reste alkyle, alcoxy, aryle, aryloxy, acycle, acyloxy, carbalcoxy ou encore un groupe nitré; deux des restes $R_4$ à $R_7$ pouvant être reliés et former un cycle, et,

n est un nombre entier de 1 à 3.

4. Mélange sensible aux rayonnements selon la revendication 2, caractérisé en ce que le composé (b), pouvant être coupé par un acide répond à la formule III

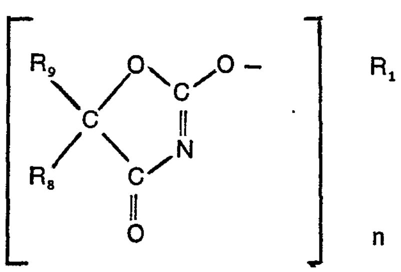

(III)

dans laquelle:

$R_1$ est un reste aromatique de valence n,

$R_8$ et $R_9$ sont des atomes d'hydrogène ou des restes alkyle et

n est un nombre entier de 1 à 3.

5. Mélange sensible aux rayonnements selon la revendication 2, caractérisé en ce que n est égal à 1 ou à 2.

6. Mélange sensible aux rayonnements selon la revendication 1, caractérisé en ce qu'il contient en plus un liant polymère insoluble dans l'eau.

7. Procédé pour la réalisation d'images en relief, selon lequel l'on irradie un matériel d'enregistrement sensible aux rayonnements, composé d'un support et d'une couche d'enregistrement, cette dernière contenant:

(a) un composé qui, sous l'effet d'un rayonnement actinique, donne naissance à un acide, et,

(b) un composé qui comporte au moins une liaison susceptible d'être coupée par un acide et dont la solubilité dans un révélateur liquide est augmentée sous l'action d'un acide, l'irradiation se faisant par un rayonnement actinique à dose telle que la solubilité de la couche dans un révélateur liquide s'accroît et que les parties exposées sont isolées au moyen d'un révélateur, caractérisé en ce que l'on utilise un composé (b) qui renferme au moins un groupe iminocarbonate N-acylé, en tant que groupe pouvant être coupé par l'acide.